# EUROPEAN PATENT APPLICATION

(11) **EP 4 697 594 A1**
(43) Date of publication of application: **18.02.2026**
(21) Application number: 25186006.0
(22) Date of filing: 27.06.2025
(51) Int. Cl.: H03F 1/02, H03F 1/56

(54) **AMPLIFIER DESIGN USING IN-PACKAGE OUTPUT MATCHING NETWORK**

(30) Priority: 25.07.2024 US 202418784806
(71) Applicant: NXP USA, Inc., Austin, TX 78735 (US)
(72) Inventor: WADODKAR, Aniket Anant, 5656AG Eindhoven (NL); USCOLA, Ricardo, 5656AG Eindhoven (NL)
(74) Representative: Hardingham, Christopher Mark

(57) **Abstract**

A device may include a transistor die including a transistor and a transistor input terminal and a transistor output terminal, and an output circuit coupled between the amplifier output and the transistor output terminal, wherein the output circuit includes: a DC blocking capacitor, a first inductance electrically connected between the transistor output terminal and a first terminal of the DC blocking capacitor, and a series-connected second inductance and a first capacitor connected, in parallel with the first inductance, between the transistor output terminal the first terminal of the DC blocking capacitor, wherein a second terminal of the DC blocking capacitor is connected to a ground node and wherein the first inductance and the series-connected second inductance and the first capacitor form at least a portion of a pseudo tank circuit in which the first inductance is configured to resonate with the first capacitor.

## Description

### FIELD

Embodiments of the subject matter described herein relate generally to radio frequency (RF) amplifiers, and more particularly to power transistor devices and amplifiers with output matching networks.

### BACKGROUND

Wireless communication systems employ power amplifiers for increasing the power of radio frequency (RF) signals. Output matching circuits are commonly implemented at the output of a power amplifier to optimize the amplifier's performance. In an amplifier that includes a power transistor device, desirable device characteristics include band stability, wider band linearizability, marginal gain, particularly at the amplifier's operational bandwidth edges, and minimization of thermal losses. In some cases, the attributes can be affected by the output characteristics of the RF amplifier device.

### SUMMARY

This Summary section is neither intended to be, nor should be, construed as being representative of the full extent and scope of the present disclosure. Additional benefits, features and embodiments of the present disclosure are set forth in the attached figures and in the description hereinbelow, and as described by the claims. Accordingly, it should be understood that this Summary section may not contain all of the aspects and embodiments claimed herein.

Additionally, the disclosure herein is not meant to be limiting or restrictive in any manner. Moreover, the present disclosure is intended to provide an understanding to those of ordinary skill in the art of one or more representative embodiments supporting the claims. Thus, it is important that the claims be regarded as having a scope including constructions of various features of the present disclosure insofar as they do not depart from the scope of the methods and apparatuses consistent with the present disclosure (including the originally filed claims). Moreover, the present disclosure is intended to encompass and include obvious improvements and modifications of the present disclosure.

In some aspects, the techniques described herein relate to a radio frequency amplifier, including: an amplifier output; a transistor die including a transistor and a transistor input terminal and a transistor output terminal; an output circuit coupled between the amplifier output and the transistor output terminal, wherein the output circuit includes: a direct-current (DC) blocking capacitor, a first inductance electrically connected between the transistor output terminal and a first terminal of the DC blocking capacitor, and a series-connected second inductance and a first capacitor connected, in parallel with the first inductance, between the transistor output terminal the first terminal of the DC blocking capacitor, wherein a second terminal of the DC blocking capacitor is connected to a ground node and wherein the first inductance and the series-connected second inductance and the first capacitor form at least a portion of a pseudo tank circuit in which the first inductance is configured to resonate with the first capacitor during operation of the radio frequency amplifier.

### BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention.

In the drawings:
FIG. 1 is a schematic diagram of an RF power amplifier circuit.
FIG. 2 is a schematic diagram of an RF power amplifier circuit in accordance with the present disclosure.
FIG. 3 is a top view of an embodiment of a packaged RF amplifier device that embodies the amplifier of FIG. 2.
FIG. 4 is a schematic depicting a Doherty amplifier including amplification paths comprising a main amplifier path and a peaking amplifier path.

### DETAILED DESCRIPTION OF THE ILLUSTRATED EMBODIMENTS

Embodiments of the subject matter described herein relate generally to radio frequency (RF) amplifiers, and more particularly to power transistor devices and amplifiers with output matching networks.

In an amplifier that includes a power transistor device characterized by nonlinear input capacitance (e.g., a device incorporating gallium nitride (GaN) transistor(s)), attributes of the device can be enhanced by fine-tuning the device's output matching network, which may provide an impedance match between the amplifier and an output load. The output matching network can also be configured to improve performance of the amplifier by reducing undesirable signal energy at harmonics of the frequencies in the amplifier's intended operating bandwidth. Such functionality is referred to as "harmonic termination". By selecting an appropriate output matching network, for example, the amplifier operations can be optimized by reducing undesirable signal energy at harmonics of the fundamental frequency of operation of the amplifier, and particularly at a second harmonic frequency.

In particular, for an amplifier operating in a class F or pseudo inverse F class mode of operation (described below), conventional topologies suffer from various problems, such as poor stability due to interactions between a dedicated output harmonic termination (OHT) circuit (e.g., a second order (twice the amplifier's fundamental frequency (f₀) termination circuit) network and other harmonic termination circuits at the amplifier's input and output. In some amplifier applications, these instabilities can be aggravated by cover or shield effects as many of the device shields used in baseband applications do not have radiation absorbing materials because such materials may not be operable at amplifier operating temperatures. In the absence of these absorbing materials, a device shield, depending on its height from the radiating amplifier may increase electromagnetic interactions between the device input and output, potentially resulting in device instability. This effect can typically be observed in devices operating at frequencies greater that 2 Gigahertz (2GHz). Further obstacles for conventional topologies can include undesirable gain characteristics (e.g., non-uniformities in gain as a function of frequency or gain dispersion), and the generation of high temperatures in the amplifier's output signal bondwires.

As described, herein, however, these difficulties can be mitigated in class F and inverse class F amplifier applications by incorporating the present output matching network that provides adequate impedance matching and harmonic termination without sacrificing other device attributes, such as the amplifier's gain, power and efficiency. Additionally, in various embodiments, the present output matching network topology may streamline Doherty amplifier implementations by reducing the need for a 90-degree offset line at the output of the amplifier's carrier amplification path. This, in turn, can reduce some losses in the amplifier printed circuit board (PCB) design as well as making PCB match widerband because the relatively narrow 90 degree line may not be required. As such, the present amplifier design can make it easier to match the impedances required for inverted Doherty operation of the amplifier.

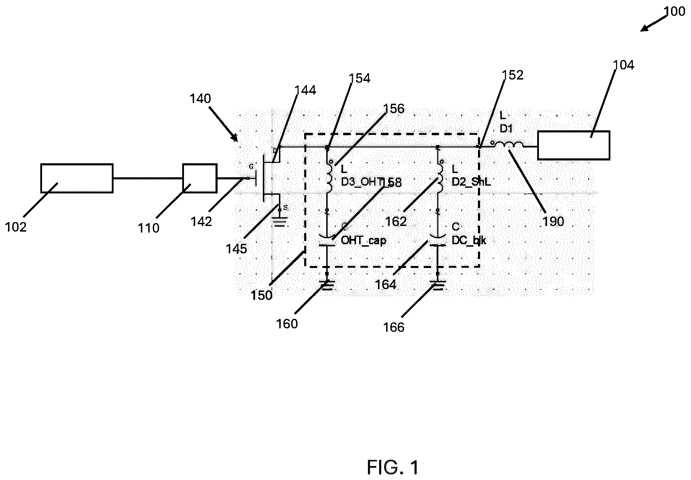

FIG. 1 is a schematic diagram of an RF power amplifier circuit 100 comprising conventional input and output matching networks. Power amplifier circuit 100 includes an input lead 102, an input network 110 that can provide an impedance match and harmonic termination function, a transistor 140, an output network 150, and an output lead 104, in an embodiment.

Each of the input and output leads 102, 104 may be more generally referred to as an "RF input/output (I/O)." Further, reference is made below to a "ground reference node." In various embodiments, a "ground reference node" is a conductive feature of a device or module (e.g. a conductive flange, a die pad, or a conductive ground plane in a printed circuit board (PCB) based module) to which terminals of various components of the power amplifier circuit 100 are coupled, where that conductive feature may be coupled to system ground (e.g., to a zero volt ground reference or to another voltage reference) when the device or module is incorporated into a larger electrical system.

Input lead 102 and output lead 104 each may include a conductor (e.g., a package lead), which is configured to enable the power amplifier circuit 100 to be electrically coupled with external circuitry (not shown). The input and output leads 102, 104 are physically positioned to span between the exterior and the interior of a device package or module. Fundamental match circuit 110 is electrically coupled between the input 102 and an input terminal 142 of transistor 140 (also referred to as a "transistor input terminal", a "control terminal" or a "gate terminal"). A first current-carrying terminal 144 of transistor 140 (e.g., the drain terminal) is coupled to the output terminal 104 through output network 150, that may include various impedance matching and harmonic filtering components, as described herein. A second current-carrying terminal 145 of transistor 140 (e.g., the source terminal) is coupled to a ground reference node.

According to an embodiment, transistor 140 is the primary active component of circuit 100. Transistor 140 includes a control terminal 142 and two current carrying terminals 144, 145, where the current-carrying terminals 144, 145 are spatially and electrically separated by a variable-conductivity channel. For example, transistor 140 may be a field effect transistor (FET), which includes a gate terminal (i.e., control terminal 142), a drain terminal (i.e., first current-carrying terminal 144), and a source terminal (i.e., second current-carrying terminal 145). According to an embodiment, and using nomenclature typically applied to FETs in a non-limiting manner, the gate terminal 142 of transistor 140 is coupled to the fundamental match circuit 110, the drain terminal 144 of transistor 140 is coupled to the output 104, and the source terminal 145 of transistor 140 is coupled to ground (or another voltage reference). Through the variation of control signals provided to the gate terminal of transistor 140, the current between the current-carrying terminals of transistor 140 may be modulated.

According to one or more embodiments, transistor 140 is a III-V field effect transistor (e.g., a high electron mobility transistor (HEMT)), which has a nonlinear input capacitance and a relatively low drain terminal-source terminal capacitance, C_{ds}, when compared with a silicon-based FET (e.g., a laterally-diffused metal oxide semiconductor (LDMOS) FET). According to an embodiment, transistor 140 may have a drain terminal-source terminal capacitance that is less than about 0.2 pF/W. In some embodiments, for example, transistor 140 may have a drain terminal-source terminal capacitance that is in the range of 0.1 pF/W to 0.2 pf/W. Further, in some embodiments, transistor 140 may be a GaN FET, although in other embodiments, transistor 140 may be another type of III-V transistor (e.g., gallium arsenide (GaAs), gallium phosphide (GaP), indium phosphide (InP), or indium antimonide (InSb)), or another type of transistor that has a nonlinear input capacitance and a relatively low drain terminal-source terminal capacitance.

Output network 150 is coupled between first current-carrying terminal 144 of transistor 140 and output lead 104. In general, output network 150 is configured to transform (e.g., raise) the impedance of first current-carrying terminal 144 of transistor 140 to a higher (e.g., intermediate or higher) impedance level (e.g., in a range from about 1 ohm to about 10 ohms or higher) at node 152. Node 152 represents the output node of output network 150 and is connected via inductance 190 (e.g., a bondwire) to output lead 104

According to an embodiment, output network 150 includes an input node 154 that is connected to first current-carrying terminal 144 of transistor 140. Shunt inductance 156 (e.g., a bondwire) is connected between input node 154 and a first terminal of capacitor 158. A second terminal of capacitor 158 is connected to ground terminal 160.

Output network 150 includes shunt inductance 162 (e.g., a bondwire) connected between input node 154 and a first terminal of capacitor 164. A second terminal of capacitor 164 is connected to ground terminal 166.

In this configuration, shunt inductance 156 and capacitor 158 form a second harmonic frequency trap of output network 150, while shunt inductance 162 and capacitor 164 provide a fundamental transformation function.

Output network 150 shown in FIG. 1 is configured to operate as a class F amplifier output pre-circuit that incorporates a second order (e.g., 2*f₀) harmonic termination circuit as implemented by the shunt inductor-capacitor (LC) network of inductance 156 and capacitor 158. In embodiments in which amplifier 100 has a class F topology, both input and output second order harmonics are shorted to ground in both fundamental match circuit 110 and output network 150 which increases interactions between the input and output of transistor 140.

To remedy these difficulties, an improved output matching network is provided herein that exhibits both fundamental frequency (f₀) and second order harmonic frequency (2*f₀) control for amplifier devices configured in class F topologies without the need of dedicated and shorted 2*f₀ LC network. The present output matching network may be implemented within the amplifier package via integrated passive devices to provide improved stability over conventional network that results from the present network's improved isolation between input and output terminals. Additionally, the present output matching network may realize reduced drain wire temperatures over conventional approaches.

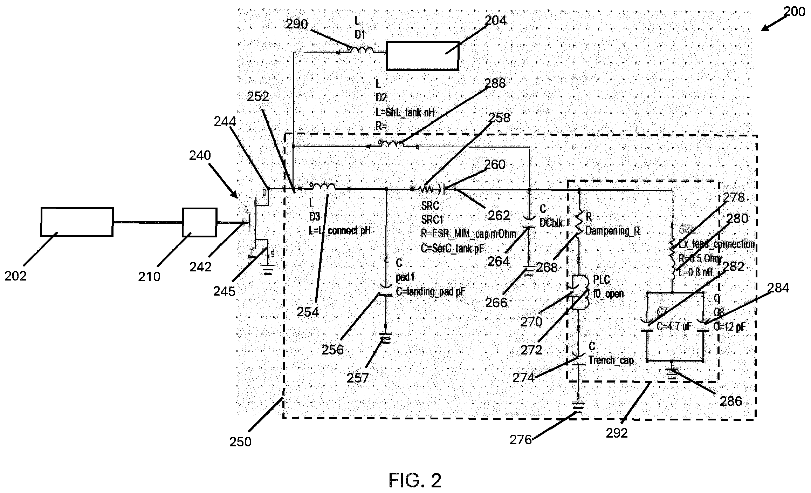

To illustrate, FIG. 2 is a schematic diagram of an RF power amplifier circuit 200. Power amplifier circuit 200 includes an input lead 202, an input impedance match and harmonic termination circuit 210, a transistor 240, an output network 250, and an output lead 204, in an embodiment.

Each of the input and output leads 202, 204 may be more generally referred to as an "RF input/output (I/O)." Further, reference is made below to a "ground reference node." In various embodiments, a "ground reference node" is a conductive feature of a device or module (e.g. a conductive flange, a die pad, or a conductive ground plane in a printed circuit board (PCB) based module) to which terminals of various components of the power amplifier circuit 200 are coupled, where that conductive feature may be coupled to system ground (e.g., to a zero volt ground reference or to another voltage reference) when the device or module is incorporated into a larger electrical system.

Input lead 202 and output lead 204 each may include a conductor (e.g., a package lead), which is configured to enable the power amplifier circuit 200 to be electrically coupled with external circuitry (not shown). More specifically, the input and output leads 202, 204 are physically positioned to span between the exterior and the interior of a device package or module, in an embodiment. Fundamental match circuit 210 is electrically coupled between the input 202 and an input terminal 242 of transistor 240 (also referred to as a "transistor input terminal", a "control terminal" or a "gate terminal"). Fundamental match circuit 210 may, in various embodiments, be implemented as a single stage low-pass network (e.g., an input T-match (ITM) circuit) or a two-stage low pass network (e.g., a dual input T-match (DITM) circuit).

A first current-carrying terminal 244 of transistor 240 (e.g., the drain terminal) is coupled to the output terminal 204 through inductance 290 (e.g., a bondwire). A second current-carrying terminal 245 of transistor 240 (e.g., the source terminal) is coupled to a ground reference node.

According to an embodiment, transistor 240 is the primary active component of circuit 200. Transistor 240 includes a control terminal 242 and two current carrying terminals 244, 245, where the current-carrying terminals 244, 245 are spatially and electrically separated by a variable-conductivity channel. For example, transistor 240 may be a FET, which includes a gate terminal (i.e., control terminal 242), a drain terminal (i.e., first current-carrying terminal 244), and a source terminal (i.e., second current-carrying terminal 245). According to an embodiment, and using nomenclature typically applied to FETs in a non-limiting manner, the gate terminal 242 of transistor 240 is coupled to the fundamental match circuit 210, the drain terminal 244 of transistor 240 is coupled to the output 204, and the source terminal 245 of transistor 240 is coupled to ground (or another voltage reference). Through the variation of control signals provided to the gate terminal of transistor 240, the current between the current-carrying terminals of transistor 240 may be modulated.

According to one or more embodiments, transistor 240 is a III-V field effect transistor (e.g., a HEMT), which has a nonlinear input capacitance and a relatively low drain terminal-source terminal capacitance, C_{ds}, when compared with a silicon-based FET (e.g., an LDMOS FET). According to an embodiment, transistor 240 may have a drain terminal-source terminal capacitance that is less than about 0.2 pF/W. In some embodiments, for example, transistor 240 may have a drain terminal-source terminal capacitance that is in the range of 0.1 pF/W to 0.2 pf/W. Further, in some embodiments, transistor 240 may be a GaN FET, although in other embodiments, transistor 240 may be another type of III-V transistor (e.g., GaAs, GaP, InP, or InSb), or another type of transistor that has a nonlinear input capacitance and a relatively low drain terminal-source terminal capacitance.

Output network 250 is coupled to first current-carrying terminal 244 of transistor 240. In general, output network 250 is configured to transform (e.g., raise) the impedance of first current-carrying terminal 244 of transistor 240 to a higher (e.g., intermediate or higher) impedance level (e.g., in a range from about 1 ohm to about 10 ohms or higher) at node 252.

According to an embodiment, output network 250 includes inductance 254 (e.g., a bondwire) connected between node 252 (and first current-carrying terminal 244 of transistor 240) and a first terminal of capacitor 256. Capacitor 256 is in a shunt arrangement and a second terminal of capacitor 256 is connected to ground node 257. The first terminal of capacitor 256 is connected to a first terminal of resistor 258. In various embodiments, capacitor 256 may be formed by all or a portion of a landing pad of power amplifier circuit 200. A second terminal of resistor 258 is connected to a first terminal of capacitor 260 at node 262. In this configuration, inductance 254 and capacitor 260 are series-connected between first current-carrying terminal 244 and shunt capacitor 264.

Three parallel branches of output network 250 are connected to node 262.

In a first branch, shunt capacitor 264 is connected between node 262 and ground node 266. In a second branch, resistor 268 is connected between node 262 and a first terminal of a circuit capacitor 270 and inductance 272 connected in parallel. A second terminal of the circuit comprising circuit capacitor 270 and inductance 272 is connected to a first terminal of capacitor 274, which may comprise a device trench capacitance. A second terminal of capacitor 274 is connected to ground node 276. In a third branch, resistor 278 is connected between node 262 and a first terminal of inductance 280. A second terminal of inductance 280 is connected to a first terminal of a circuit that includes capacitor 282 and capacitor 284 in parallel. A second terminal of the circuit that includes capacitor 282 and capacitor 284 is connected to ground node 286. Inductance 288 is connected between node 252 and node 262.

In this configuration, within output network 250, inductance 290 may be implemented by one or more bond wires that are connected between an output terminal that represents first current-carrying terminal 244 of transistor 240 and a package terminal that operates as output lead 204 of device 200. Inductance 288 operates as part of a pseudo tank circuit that provides fundamental frequency (f₀) control. The pseudo tank circuit is made up of inductances 288 and 254 and capacitor 260 with resistor 258 represent the equivalent series resistance of capacitor 260. During operation, components 288, 254 and 260 of the pseudo tank circuit resonate with each other to provide f0, 2f0 and 3f0 control. Furthermore, inductance 288 resonates with capacitor 264 to provide enhanced fundamental frequency f0 control. Capacitor 264 operates as a direct-current (DC) blocking capacitor. Furthermore, with reference to FIG. 2, components of power amplifier circuit 200 contained within dashed block 292 provide a baseband decoupling operation enabling the components of dashed block 292 to shunt signal energy received from transistor 240 at or near a baseband frequency of the radio frequency amplifier to a ground node (e.g., ground node 276 and/or ground node 286).

Consequently, in this configuration, output network 250 as illustrated in FIG. 2 and described herein provides fundamental frequency (f₀) and second order harmonic (2*f₀) control for class F topology amplifiers. In implementations, second order harmonic frequencies are shorted to ground, while the 3rd harmonic is close to open. In an example implementation of amplifier 200, capacitor 260 may have a capacitance value that ranges from 10 picoFarads (pF) to 25pF, inductance 254 may have an inductance value that ranges from 10 picoHenries (pH) to 60pH, and inductance 288 may have an inductance that ranges from 50 pH to 500pH. Capacitor 260 may be a relatively high Q capacitor configured to reduce resistor 258 (again, which represents the equivalent series resistance of capacitor 260) to a lower value. Capacitor 264 may have a capacitance value of 100pF or greater.

Portions of output network 250 operates as a pseudo tank circuit connected between first current-carrying terminal 244 of transistor 240 and a DC blocking circuit. The absence of shunt L/C circuits in output network 250 (as compared, for example, to the L/C shunt circuits of output network 150 of FIG. 1), can improve overall amplifier stability due to improved isolation between the amplifier input and output. The temperature of output signal wires can be managed and potentially reduced in output network 250 by increasing the capacitance of capacitor 260 and by increasing the capacitance of capacitor 256.

The pseudo tank circuit of output network 250 resonates at a frequency above the fundamental band of interest f₀ but in combination with the drain source capacitance (C_{ds}) of transistor 240 the fundamental output resonance of the pseudo tank circuit is placed below band of operation and helps orient the max P3dB power point and max P3dB efficiency point (MXP/MXE) in a manner suitable for incorporation into dual path (e.g., Doherty) amplifiers.

Although transistor 240 and various elements of output network 250 are shown as singular components, the depiction is for the purpose of ease of explanation only. Those of skill in the art would understand, based on the description herein, that transistor 240 and/or certain elements of output network 250 each may be implemented as multiple components (e.g., connected in parallel or in series with each other). Further, embodiments may include single-path devices (e.g., including a single input lead, output lead, transistor, etc.), dual-path devices (e.g., including two input leads, output leads, transistors, etc.), and/or multi-path devices (e.g., including two or more input leads, output leads, transistors, etc.). Further, the number of input/output leads may not be the same as the number of transistors (e.g., there may be multiple transistors operating in parallel for a given set of input/output leads). The specific description of transistor 240 and various elements of output network 250 thus are not intended to limit the scope of the inventive subject matter only to the illustrated embodiments.

Referring again to FIG. 2, various embodiments of RF amplifier devices may include at least one input-side integrated passive devices (IPDs) configured to implement portions of output network 250. More specifically, each IPD may include a semiconductor substrate with one or more integrated passive components.

In other embodiments, some portions of output network 250 may be implemented as distinct/discrete components or as portions of other types of assemblies (e.g., a low-temperature co-fired ceramic (LTCC) device, a small PCB assembly, and so on). In still other embodiments, some portions of output network 250 may be coupled to and/or integrated within the semiconductor die that includes transistor 240. The below detailed description of embodiments that include IPDs should not be taken to limit the inventive subject matter, and the term "passive device substrate" or "IPD substrate" means any type of structure that includes a passive device, including an IPD, a LTCC device, a transistor die, a PCB assembly, and so on.

Amplifier 200 may be implemented in a discrete, packaged power amplifier device, in some embodiments, or in a PCB-based module, in other embodiments. In such devices, input lead 202 and output lead 204 can be coupled to a support substrate, and components associated with the amplifier 200 also are coupled to the substrate. A power amplifier die housing transistor 240, along with output network 250, can be included as some of these components within the packaged device or module.

Once implemented within such a packaged device or module, amplifier 200 can be incorporated into a larger system device, such as a high-power RF amplifier. In the field of high-power RF power amplifiers (e.g., for use in cellular base stations and other applications, broadband power amplification using silicon-based devices (e.g., LDMOS power transistor devices with output matching networks) has been successfully achieved. However, such silicon-based devices can, in some circumstances, exhibit relatively low efficiencies and power densities when compared with the efficiencies and power densities of GaN-based power amplifier devices.

Accordingly, GaN-based power amplifier devices have been increasingly considered for high power broadband applications. However, there are challenges to using GaN technology to achieve broadband power amplification (e.g., over 20 percent fractional bandwidth).

For example, nonlinear input capacitance of RF power devices associated with some GaN transistors are known to generate harmonics and intermodulation distortion that can impair efficiency and linearity. For example, signal energy at the second harmonic of the center frequency of operation (f0), of the amplifier 200 (also referred to herein as the "fundamental frequency" of operation) may degrade the performance of the amplifier, if not compensated for.

Accordingly, second harmonic termination circuits can also play an important role in the overall performance of a power amplifier design that uses GaN-based transistors. Without the information of second harmonic impedance at the current source terminal plane, it can be difficult to tune a power amplifier to achieve relatively high fractional bandwidth with good performance. Furthermore, the second harmonic termination may vary significantly across a large bandwidth for broadband applications, which can further increase the difficulty of circuit tuning.

To overcome or potentially mitigate these and other challenges in designing broadband power amplifiers using GaN-based devices, embodiments disclosed herein can include "pseudo" inverse class F amplifier circuits, partially implemented with a high-power packaged power transistor device with unique, in-package, input and output impedance matching topologies.

Class F and inverse class F amplifiers are characterized by having a 50 percent conduction angle and can operate in a switching mode. A conventional class F amplifier may include one or more odd harmonic resonators in its output network to shape the drain-to-source voltage (V_{DS}) so that the transistor switching loss is reduced and the efficiency is increased. In contrast, a conventional inverse class F amplifier may have one or more even harmonic resonators in its output network to shape the drain-to-source voltage (e.g., to shape the drain current to be a square wave and the drain-to-source voltage to be a sine wave).

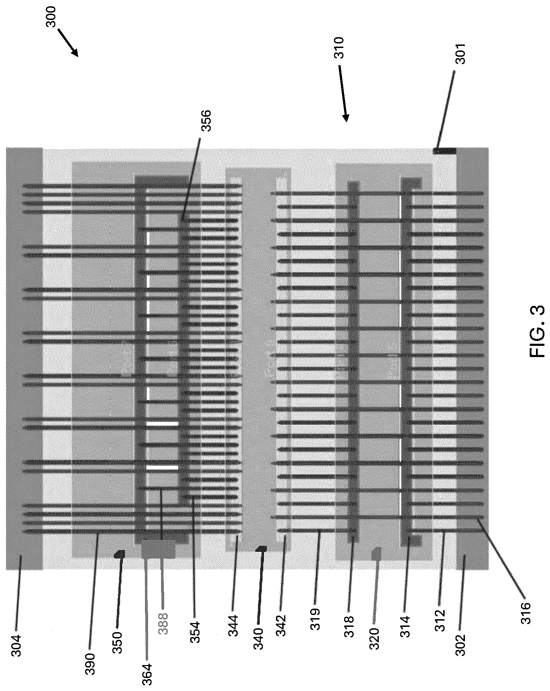

FIG. 3 is a top view of an embodiment of a packaged RF amplifier device 300 that embodies amplifier 200 of FIG. 2. As will be described in more detail below, device 300 includes a power transistor die 340 (e.g., including transistor 240 of FIG. 2) and an input-side IPD 320. IPD 320 includes components configured to implement, for example 210// of FIG. 2.

Device 300 includes a flange 301 (or "device substrate"), in an embodiment, which may include a rigid electrically- and thermally-conductive substrate with a thickness that is sufficient to provide structural support for various electrical components and elements of device 300. Flange 301 has top and bottom surfaces, where the top surface is visible in FIG. 3. According to an embodiment, flange 301 may function as a heat sink for transistor die 340. Further, flange 301 may correspond to a ground reference node for the device 300 (and more particularly for transistor die 340 and IPDs 320 and 350). For example, various components and elements may have terminals that are electrically coupled to flange 301, and flange 301 may be electrically coupled to a system ground when the device 300 is incorporated into a larger electrical system. At least the top surface of flange 301 is formed from a layer of conductive material, and possibly all of flange 301 is formed from bulk conductive material.

Although not shown in FIG. 3, an isolation structure may be attached to the top surface of flange 301, in one or more embodiment. The isolation structure, which is formed from a rigid, electrically insulating material, provides electrical isolation between conductive features of the device (e.g., between leads 302 (e.g., lead 202 of FIG. 2), 204 (e.g., lead 204 of FIG. 2) and flange 301). The isolation structure may have a frame shape, in an embodiment, which includes a substantially enclosed, four-sided structure with a central opening. Alternatively, the isolation structure may have another shape (e.g., annular ring, oval, and so on).

A portion of the top surface of flange 301 that is exposed through the opening in the isolation structure is referred to herein as the "active area" of device 300. Transistor die 340 and IPDs 320 and 350 are positioned within the active device area of device 300, and are physically and electrically coupled to the top surface of the flange 301. For example, the transistor die 340 and IPDs 320 and 350 may be coupled to the top surface of flange 301 using conductive epoxy, solder, solder bumps, sintering, and/or eutectic bonds.

Device 300 may be incorporated in an air cavity package, in which the power transistor die 340 and the IPDs 320 and 350 are located within an enclosed air cavity. In that case, the air cavity is bounded by flange 301, the isolation structure (not shown), and a cap (not shown) overlying and in contact with the isolation structure and leads 302 and 304. In other embodiments, the components of device 300 may be incorporated into an overmolded package (i.e., a package in which the electrical components within the active area of the device are encapsulated with a non-conductive molding compound, and in which portions of the package leads 302, 304 also may be encompassed by the molding compound). In still other embodiments, the components of device 300 may be incorporated into a no-leads package (e.g., a dual flat no-leads (DFN) or quad flat no-leads (QFN) package), or into other types of packages.

Regardless of the type of packaging utilized, device 300 houses an amplification path that represents a physical implementation of amplifier circuit 200 (FIG. 2). The amplification path embodied in device 300 includes an input lead 302 (e.g., input 202, FIG. 2), an output lead 304 (e.g., output 204, FIG. 2), a power transistor die 340 (e.g., embodying transistor 240, FIG. 2), an input-side impedance and harmonic termination circuit matching circuit 310 (e.g., fundamental match circuit 210 of FIG. 2). Device 200 includes an output matching network implemented at least partially by IPD 350 (e.g., output network 250 of FIG. 2) that may include an output-side impedance matching circuit and/or an output-side harmonic termination circuit, as described above.

The input and output leads 302, 304 may be mounted on a top surface of the isolation structure on opposed sides of the central opening. Generally, the input and output leads 302, 304 are oriented to allow for attachment of bond wires between the input and output leads 302, 304 and components and elements within the central opening of isolation structure.

Transistor die 340 includes an integrated power transistor (e.g., transistor 240, FIG. 2). The transistor of transistor die 340 has input terminal 342 (e.g., input terminal 242, FIG. 2) and two current-carrying terminals including output terminal 344 (e.g., output/drain terminal 344) and a source terminal (not shown in FIG. 3) (e.g., source terminal 245, FIG. 2) that may be connected to flange 301 as a ground reference node.

Output terminal 344 of transistor die 340 is connected to output leads 304 through sets of bond wires and other electrical structures implemented within IPDs 350. Similarly, input terminal input terminal 342 of transistor die 340 is connected to input lead 302 through sets of bond wires and other electrical structures implemented within IPDs 320. Note that, in FIG. 3, for convenience of illustration, only one bondwire is referenced for each of the various sets of bond wires discussed herein. In this approach, all bondwires that connect between the same two elements are considered to be within the same set of bondwires. Further, although in FIG. 3 each set of bond wires is shown to include a particular number of bond wires, each set of bond wires may include fewer or more bond wires than is illustrated. Generally, for any particular set of bond wires, the number of bond wires and the bond wire profile/length determine a desired inductance value associated with the set of bond wires.

As illustrated in FIG. 3, leads 302 is connected by bondwires 312 to a first terminal 314 of a capacitor structure within IPDs 320. A second terminal of that capacitor structure is connected to a ground node through flange 301. Bondwires 316 are connected between leads 302 and input terminal 342 of 340. IPDs 320 includes a second capacitor structure. A first terminal of capacitor structure 318 is connected to input terminal 342 by bondwires 319. A second terminal of that capacitor structure is connected to a ground node through flange 301.

The combination of bondwires 312, bondwires 316, the capacitor structures of IPDs 320 and bondwires 319 for, in combination, an impedance match and harmonic termination circuit (e.g., fundamental match circuit 210 of FIG. 2).

On the output side, output terminal 344 of transistor die 340 is connected to output leads 304 by bondwires 390 (e.g., inductance 290 of FIG. 2). Output terminal 344 is connected by bondwires 354 (e.g., inductance 254 of FIG. 2) to a first terminal 356 of a capacitor structure (e.g., capacitor 256 of FIG. 2) in IPD 350. A second terminal of that capacitor structure is connected to a ground node through flange 301.

Bondwires 388 (e.g., inductance 288 of FIG. 2) are connected between output terminal 344 of transistor die 340 and a first terminal 364 of a capacitor structure (e.g., shunt capacitor 264 of FIG. 2). A second terminal of that capacitor structure is connected to a ground node through flange 301.

In various embodiments, a capacitor and its integrated equivalent series resistance (e.g., capacitor 260 and resistor 258 of FIG. 2) (not shown in FIG. 3) are connected between first terminal 356 and first terminal 364, where the capacitor and its resistance may be implemented as components within IPD 350 or as components external to IPD 350. Dashed block 292.

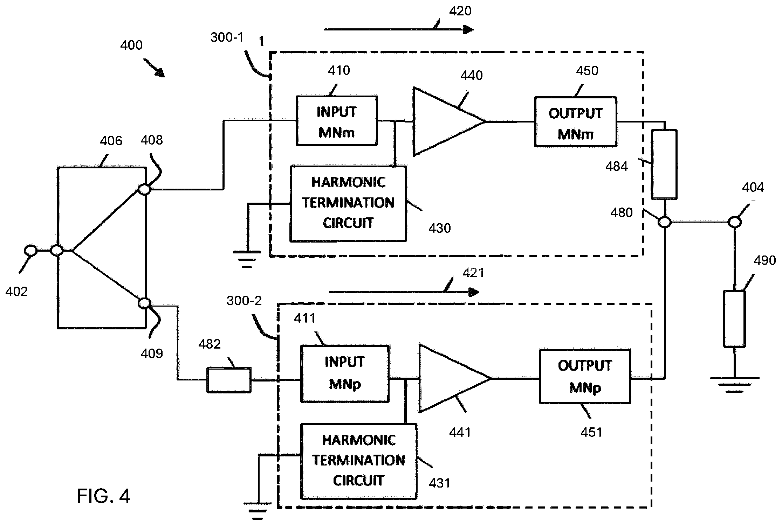

Device 300 (and the corresponding device 200 of FIG. 2) embodies a single amplification path between input and output leads 302, 304. When incorporated into a multiple-path amplifier, such as the Doherty amplifier 400 described below in conjunction with FIG. 4 , the amplification path embodied in device 300 may correspond to a main amplifier path (e.g., main amplifier path 420, FIG. 4), or the amplification path may correspond to a peaking amplifier path (e.g., peaking amplifier path 421, FIG. 4). Accordingly, two instances of device 300 may be utilized to provide both the main and peaking amplifier paths of the Doherty amplifier, although some of the individual components may have differences (e.g., the power transistor in the peaking amplifier path may be larger than the power transistor in the main amplifier path). In an alternate embodiment, device 300 could be modified to include two amplification paths implemented in parallel within the same package (e.g., the device could include two input leads, two output leads, and two instances of the circuitry depicted in FIG. 3), in order to be more efficiently utilized in a multiple-path amplifier.

For example, FIG. 4 is a simplified schematic diagram of a Doherty power amplifier 400 in which two parallel instances of device 300 may be implemented. Amplifier 400 includes an input node 402, an output node 404, a power divider 406 (or splitter), a main amplifier path 420, a peaking amplifier path 421, and a combining node 480. A load 490 may be coupled to the combining node 480 (e.g., through an impedance transformer, not shown) to receive an amplified RF signal from amplifier 400.

Power divider 406 is configured to divide the power of an input RF signal received at input node 402 into main and peaking portions of the input signal. The main input signal is provided to the main amplifier path 420 at power divider output 408, and the peaking input signal is provided to the peaking amplifier path 421 at power divider output 409. During operation in a full-power mode when both the main and peaking amplifiers 440, 441 are supplying current to the load 490, the power divider 406 divides the input signal power between the amplifier paths 420, 421. For example, the power divider 406 may divide the power equally, such that roughly one half of the input signal power is provided to each path 420, 421 (e.g., for a symmetric Doherty amplifier configuration). Alternatively, the power divider 406 may divide the power unequally (e.g., for an asymmetric Doherty amplifier configuration).

Essentially, the power divider 406 divides an input RF signal supplied at the input node 402, and the divided signals are separately amplified along the main and peaking amplifier paths 420, 421. The amplified signals are then combined in phase at the combining node 480. It can be important that phase coherency between the main and peaking amplifier paths 420, 421 is maintained across a frequency band of interest to ensure that the amplified main and peaking signals arrive in phase at the combining node 480, and thus to ensure proper Doherty amplifier operation.

Each of the main amplifier 440 and the peaking amplifier 441 includes one or more single-stage or multiple-stage power transistor dies (e.g., die 340, FIG. 3) for amplifying an RF signal conducted through the amplifier 440, 441. According to various embodiments, all amplifier stages or a final amplifier stage of either or both the main amplifier 440 and/or the peaking amplifier 441 may be implemented, for example, using a III-V field effect transistor (e.g., a HEMT), such as a GaN FET (or another type of III-V transistor, including a GaAs FET, a GaP FET, an InP FET, or an InSb FET). Where only one of the main amplifier 440 or the peaking amplifier 441 is implemented as a III-V FET, the other amplifier may be implemented as a silicon-based FET (e.g., an LDMOS FET), in some embodiments.

Although the main and peaking power transistor dies may be of equal size (e.g., in a symmetric Doherty configuration), the main and peaking power transistor dies may have unequal sizes, as well (e.g., in various asymmetric Doherty configurations). In an asymmetric Doherty configuration, the peaking power transistor die typically is larger than the main power transistor die by some multiplier. For example, the peaking power transistor die may be twice the size of the main power transistor die so that the peaking power transistor die has twice the current-carrying capability of the main power transistor die. Peaking-to-main amplifier die size ratios other than a 2:1 ratio may be implemented, as well.

During operation of Doherty amplifier 400, the main amplifier 440 is biased to operate in class AB mode, and the peaking amplifier 441 is biased to operate in class C mode. At low power levels, where the power of the input signal at node 402 is lower than the turn-on threshold level of peaking amplifier 441, the amplifier 400 operates in a low-power (or back-off) mode in which the main amplifier 440 is the only amplifier supplying current to the load 490. When the power of the input signal exceeds a threshold level of the peaking amplifier 441, the amplifier 400 operates in a high-power mode in which the main amplifier 440 and the peaking amplifier 441 both supply current to the load 490. At this point, the peaking amplifier 441 provides active load modulation at combining node 480, allowing the current of the main amplifier 440 to continue to increase linearly.

Input and output impedance matching networks 410, 450 (input MNm, output MNm) may be implemented at the input and/or output of the main amplifier 440. Similarly, input and output impedance matching networks 411, 451 (input MNp, output MNp) may be implemented at the input and/or output of the peaking amplifier 441. In each case, the matching networks 410, 411, 450, 451 may be used to transform the gate and drain impedances of main amplifier 440 and peaking amplifier 441 to a more desirable system level impedance, as well as manipulate the signal phases to ensure proper Doherty amplifier operation. All or portions of the input and output impedance matching networks 410, 411, 450, 451 may be implemented inside a power transistor package that includes the main and/or peaking amplifiers 440, 441, or some portions of the input and output impedance matching networks 410, 411, 450, 451 may be implemented on a PCB or other substrate to which a power transistor package is mounted. According to an embodiment, each of the output matching networks 450, 451 may have the same or similar configuration as output network 250 of FIG. 2 described above.

In addition, embodiments of the inventive subject matter include harmonic frequency termination circuits 430, 431 coupled between the inputs of amplifiers 440, 441 and a ground reference node. The harmonic termination circuits 430, 431 are configured to control the harmonic impedance across a relatively wide fractional bandwidth. For example, the harmonic termination circuits 430, 431 may provide a low impedance path to ground for signal energy at the second harmonic of the fundamental frequency of operation of the amplifier 400.

As indicated in FIG. 4 with dashed-line boxes 300-1, 300-2, the input matching circuit 410, amplifier 440, harmonic termination circuit 430, and output network 450 for the main amplification path 420 may be implemented using a first instance of device 300, and the input matching circuit 411, amplifier 441, harmonic termination circuit 431, and output network 451 for the peaking amplification path 421 may be implemented using a second instance of device 300. In an alternate embodiment, and as discussed previously, the above-listed components for the main and peaking amplification paths may be combined into a single package body.

Doherty amplifier 400 has a "non-inverted" load network configuration. In the non-inverted configuration, the input circuit is configured so that an input signal supplied to the peaking amplifier 441 is delayed by 90 degrees with respect to the input signal supplied to the main amplifier 440 at the fundamental frequency of operation of the amplifier 400. To ensure that the main and peaking input RF signals arrive at the main and peaking amplifiers 440, 441 with about 90 degrees of phase difference, as is fundamental to proper Doherty amplifier operation, phase delay element 482 applies about 90 degrees of phase delay to the peaking input signal. For example, phase delay element 482 may include a quarter wave transmission line, or another suitable type of delay element with an electrical length of about 90 degrees.

To compensate for the resulting 90 degree phase difference between the main and peaking amplifier paths 420, 421 at the inputs of amplifiers 440, 441 (i.e., to ensure that the amplified signals arrive in phase at the combining node 480), the output circuit is configured to apply about a 90 degree phase delay to the signal between the output of main amplifier 440 and the combining node 480. This is achieved through an additional delay element 484. Alternate embodiments of Doherty amplifiers may have an "inverted" load network configuration. In such a configuration, the input circuit is configured so that an input signal supplied to the main amplifier 440 is delayed by about 90 degrees with respect to the input signal supplied to the peaking amplifier 441 at the center frequency of operation of the amplifier 400, and the output circuit is configured to apply about a 90 degree phase delay to the signal between the output of peaking amplifier 441 and the combining node 480.

In some aspects, the techniques described herein relate to a radio frequency amplifier, including: an amplifier output; a transistor die including a transistor and a transistor input terminal and a transistor output terminal; an output circuit coupled between the amplifier output and the transistor output terminal, wherein the output circuit includes: a direct-current (DC) blocking capacitor, a first inductance electrically connected between the transistor output terminal and a first terminal of the DC blocking capacitor, and a series-connected second inductance and a first capacitor connected, in parallel with the first inductance, between the transistor output terminal the first terminal of the DC blocking capacitor, wherein a second terminal of the DC blocking capacitor is connected to a ground node and wherein the first inductance and the series-connected second inductance and the first capacitor form at least a portion of a pseudo tank circuit in which the first inductance is configured to resonate with the first capacitor during operation of the radio frequency amplifier.

In some aspects, the techniques described herein relate to a radio frequency amplifier, wherein the output circuit includes a baseband decoupling circuit configured to shunt signal energy at or near a baseband frequency of the radio frequency amplifier to the ground node.

In some aspects, the techniques described herein relate to a radio frequency amplifier, further including a node between the second inductance and the first capacitor and a second capacitor electrically connected between the node and the ground node.

In some aspects, the techniques described herein relate to a radio frequency amplifier, wherein the second capacitor includes a landing pad of the radio frequency amplifier.

In some aspects, the techniques described herein relate to a radio frequency amplifier, wherein the DC blocking capacitor and the first capacitor are incorporated into a first integrated passive device.

In some aspects, the techniques described herein relate to a radio frequency amplifier, further including a device substrate and wherein the transistor die and the first integrated passive device are mounted to the device substrate.

In some aspects, the techniques described herein relate to a radio frequency amplifier, wherein the device substrate includes a conductive flange and the conductive flange is the ground node.

In some aspects, the techniques described herein relate to a radio frequency amplifier, wherein the output circuit is configured to shunt signal energy at or near a second harmonic frequency of a fundamental frequency of operation of the radio frequency amplifier to the ground node, while appearing as an open circuit to signal energy at the fundamental frequency.

In some aspects, the techniques described herein relate to a radio frequency amplifier, further including an input network connected to the transistor input terminal and wherein the input network is configured to shunt signal energy at or near the second harmonic frequency of the fundamental frequency of operation of the radio frequency amplifier to the ground node, while appearing as an open circuit to signal energy at the fundamental frequency.

In some aspects, the techniques described herein relate to a radio frequency amplifier, wherein the transistor has a nonlinear input capacitance.

In some aspects, the techniques described herein relate to a radio frequency amplifier, wherein the transistor is a gallium nitride transistor.

In some aspects, the techniques described herein relate to a radio frequency amplifier, including: a transistor die including a transistor including a transistor input terminal and a transistor output terminal; an input circuit coupled to the transistor input terminal, wherein the input circuit include a fundamental match circuit; an output circuit coupled to the transistor output terminal, wherein the output circuit includes: a first capacitor, a first inductance electrically connected between the transistor output terminal and a first terminal of the first capacitor, and a series-connected second inductance and a second capacitor connected, in parallel with the first inductance, between the transistor output terminal the first terminal of the first capacitor, wherein a second terminal of the first capacitor is connected to a ground node.

In some aspects, the techniques described herein relate to a radio frequency amplifier, wherein the output circuit includes a baseband decoupling circuit configured to shunt signal energy at or near a baseband frequency of the radio frequency amplifier to the ground node.

In some aspects, the techniques described herein relate to a radio frequency amplifier, wherein the first capacitor and the second capacitor are incorporated into a first integrated passive device.

In some aspects, the techniques described herein relate to a radio frequency amplifier, further including a device substrate and wherein the transistor die and the first integrated passive device are mounted to the device substrate.

In some aspects, the techniques described herein relate to a radio frequency amplifier, wherein the device substrate includes a conductive flange and the conductive flange is the ground node.

In some aspects, the techniques described herein relate to a radio frequency amplifier, wherein the input circuit is configured to shunt signal energy at or near a second harmonic frequency of a fundamental frequency of operation of the radio frequency amplifier to the ground node, while appearing as an open circuit to signal energy at the fundamental frequency.

In some aspects, the techniques described herein relate to a device, including: a device substrate; a transistor die on the device substrate, wherein the transistor die includes a transistor and a transistor input terminal and a transistor output terminal; and an output circuit on the device substrate, wherein the output circuit is coupled to the transistor output terminal, wherein the output circuit includes: a direct-current (DC) blocking capacitor, a first inductance electrically connected between the transistor output terminal and a first terminal of the DC blocking capacitor, and a series-connected second inductance and a first capacitor connected, in parallel with the first inductance, between the transistor output terminal the first terminal of the DC blocking capacitor, wherein a second terminal of the DC blocking capacitor is connected to a ground node and wherein the first inductance and the series-connected second inductance and the first capacitor form at least a portion of a pseudo tank circuit in which the first inductance is configured to resonate with the first capacitor during operation of the device.

In some aspects, the techniques described herein relate to a device, wherein the device substrate includes a conductive flange and the conductive flange is the ground node.

In some aspects, the techniques described herein relate to a device, wherein the transistor is a gallium nitride transistor.

As will be appreciated by one skilled in the art, aspects of the present disclosure may be embodied as a system, process, method, and/or program product. The block diagrams in the figures illustrate architecture, functionality, and operation of possible implementations of circuitry, systems, methods, processes, and program products according to various embodiments of the present disclosure. In this regard, certain blocks in the block diagrams may represent a module, segment, or portion of code, which includes one or more executable program instructions for implementing the specified logical function(s). It should also be noted that, in some implementations, the functions noted in the blocks may occur out of the order noted in the figures. For example, two blocks shown in succession may, in fact, be executed substantially concurrently, or the blocks may sometimes be executed in the reverse order, depending upon the functionality involved.

The preceding detailed description is merely illustrative in nature and is not intended to limit the embodiments of the subject matter or the application and uses of such embodiments.

As used herein, the word "exemplary" means "serving as an example, instance, or illustration." Any implementation described herein as exemplary is not necessarily to be construed as preferred or advantageous over other implementations. Furthermore, there is no intention to be bound by any expressed or implied theory presented in the preceding technical field, background, or detailed description.

The connecting lines shown in the various figures contained herein are intended to represent exemplary functional relationships and/or physical couplings between the various elements. It should be noted that many alternative or additional functional relationships or physical connections may be present in an embodiment of the subject matter. In addition, certain terminology may also be used herein for the purpose of reference only, and thus are not intended to be limiting, and the terms "first", "second" and other such numerical terms referring to structures do not imply a sequence or order unless clearly indicated by the context.

As used herein, a "node" means any internal or external reference point, connection point, junction, signal line, conductive element, or the like, at which a given signal, logic level, voltage, data pattern, current, or quantity is present. Furthermore, two or more nodes may be realized by one physical element (and two or more signals can be multiplexed, modulated, or otherwise distinguished even though received or output at a common node).

The foregoing description refers to elements or nodes or features being "connected" or "coupled" together. As used herein, unless expressly stated otherwise, "connected" means that one element is directly joined to (or directly communicates with) another element, and not necessarily mechanically. Likewise, unless expressly stated otherwise, "coupled" means that one element is directly or indirectly joined to (or directly or indirectly communicates with, electrically or otherwise) another element, and not necessarily mechanically. Thus, although the schematic shown in the figures depict one exemplary arrangement of elements, additional intervening elements, devices, features, or components may be present in an embodiment of the depicted subject matter.

While at least one exemplary embodiment has been presented in the foregoing detailed description, it should be appreciated that a vast number of variations exist. It should also be appreciated that the exemplary embodiment or embodiments described herein are not intended to limit the scope, applicability, or configuration of the claimed subject matter in any way. Rather, the foregoing detailed description will provide those skilled in the art with a convenient road map for implementing the described embodiment or embodiments. It should be understood that various changes can be made in the function and arrangement of elements without departing from the scope defined by the claims, which includes known equivalents and foreseeable equivalents at the time of filing this patent application.

## Claims

1. A radio frequency amplifier, comprising:
an amplifier output;
a transistor die including a transistor and a transistor input terminal and a transistor output terminal;
an output circuit coupled between the amplifier output and the transistor output terminal, wherein the output circuit includes:
a direct-current, DC, blocking capacitor,
a first inductance electrically connected between the transistor output terminal and a first terminal of the DC blocking capacitor, and
a series-connected second inductance and a first capacitor connected, in parallel with the first inductance, between the transistor output terminal the first terminal of the DC blocking capacitor, wherein a second terminal of the DC blocking capacitor is connected to a ground node and wherein the first inductance and the series-connected second inductance and the first capacitor form at least a portion of a pseudo tank circuit in which the first inductance is configured to resonate with the first capacitor during operation of the radio frequency amplifier.

2. The radio frequency amplifier of claim 1, wherein the output circuit includes a baseband decoupling circuit configured to shunt signal energy at or near a baseband frequency of the radio frequency amplifier to the ground node.

3. The radio frequency amplifier of claim 1 or 2, further comprising a node between the second inductance and the first capacitor and a second capacitor electrically connected between the node and the ground node.

4. The radio frequency amplifier of claim 3, wherein the second capacitor includes a landing pad of the radio frequency amplifier.

5. The radio frequency amplifier of any preceding claim, wherein the DC blocking capacitor and the first capacitor are incorporated into a first integrated passive device.

6. The radio frequency amplifier of claim 5, further comprising a device substrate and wherein the transistor die and the first integrated passive device are mounted to the device substrate.

7. The radio frequency amplifier of claim 6, wherein the device substrate includes a conductive flange and the conductive flange is the ground node.

8. The radio frequency amplifier of any preceding claim, wherein the output circuit is configured to shunt signal energy at or near a second harmonic frequency of a fundamental frequency of operation of the radio frequency amplifier to the ground node, while appearing as an open circuit to signal energy at the fundamental frequency.

9. The radio frequency amplifier of claim 8, further comprising an input network connected to the transistor input terminal and wherein the input network is configured to shunt signal energy at or near the second harmonic frequency of the fundamental frequency of operation of the radio frequency amplifier to the ground node, while appearing as an open circuit to signal energy at the fundamental frequency.

10. The radio frequency amplifier of any preceding claim, wherein the transistor has a nonlinear input capacitance.

11. The radio frequency amplifier of claim 10, wherein the transistor is a gallium nitride transistor.
